# EUROPEAN PATENT APPLICATION

(11) **EP 3 849 288 A1**
(43) Date of publication of application: **14.07.2021**
(21) Application number: 21150429.5
(22) Date of filing: 06.01.2021
(51) Int. Cl.: H05K 3/46, H05K 1/02, G02F 1/1362, G09G 3/32, H01L 27/32, H01L 27/12

(54) **DISPLAY DEVICE AND MANUFACTURING METHOD THEREOF**

(30) Priority: 13.01.2020 KR 20200004163
(71) Applicant: Samsung Display Co., Ltd., Yongin-si, Gyeonggi-Do 17113 (KR)
(72) Inventor: KIM, Seong-Min, Gyeonggi-Do (KR); PARK, Won Mo, Gyeonggi-Do (KR); CHUNG, Jin Koo, Gyeonggi-Do (KR); JANG, Kyung Soo, Gyeonggi-do (KR); JIN, Min Hyun, Gyeonggi-do (KR); CHOI, Beohm Rock, Seoul (KR)
(74) Representative: Taor, Simon Edward William

(57) **Abstract**

A display device includes gate lines disposed on a substrate 110 in a first direction, data lines 171 disposed on the substrate 110 in a second direction crossing the first direction, the data lines being insulated from the gate lines by a gate insulating film 140, a first insulating film 181 disposed between the data lines, a second insulating film 182 disposed on the data lines and the first insulating film, and a first electrode 191 disposed on the second insulating film. The first insulating film 181 does not overlap the data lines 171 in a direction DR3 perpendicular to the substrate.

## Description

### CROSS-REFERENCE TO RELATED APPLICATION(S)

This application claims priority to and benefits of Korean Patent Application No. 10-2020-0004163 under 35 U.S.C. §119, filed in the Korean Intellectual Property Office on January 13, 2020.

### BACKGROUND

### 1. Technical Field

The disclosure relates to a display device and a manufacturing method thereof that may improve light scattering and minimize outgas generation of an organic layer.

### 2. Description of the Related Art

A liquid crystal display and a light emitting diode display may be representative examples of a display device. Among them, the light emitting diode display has excellent luminance and viewing angle characteristics as compared to the liquid crystal display and does not require a backlight, and thus may be implemented in a thin shape. The light emitting diode display forms excitons by recombining electrons and holes injected through a cathode and an anode on an organic thin film, and uses a phenomenon that generates light with a specific wavelength by energy provided by the excitons.

Recently, display devices have been widely applied not only to a computer monitor and a television, but also to a display device of a vehicle navigator system and a portable display device such as a laptop and a mobile phone. In case that the display device may be used in an environment with a lot of external light, light scattering may occur at an electrode of the display device, which may reduce display quality of the display device.

The above information disclosed in this Background section is only for enhancement of understanding of the background of the invention, and therefore it may contain information that does not form what was already known to a person of ordinary skill in the art prior to a corresponding effective filing date of the subject matter disclosed herein.

### SUMMARY

Embodiments provide display devices and manufacturing methods thereof that may improve light scattering and minimize outgas generation.

An embodiment of the invention provides a display device that may include gate lines disposed on a substrate in a first direction, data lines disposed on the substrate in a second direction crossing the first direction, the data lines being insulated from the gate lines, a first insulating film disposed between the data lines, a second insulating film disposed on the data lines and the first insulating film, and a first electrode disposed on the second insulating film. The first insulating film may not overlap the data lines in a direction perpendicular to the substrate.

A sum of thicknesses of the first insulating film and the second insulating film may be about 1.0 µm to about 2.0 µm.

The data lines and the second insulating film may directly contact each other.

A thickness of a portion of the first insulating film closer to a data line may be smaller than a thickness of a portion of the first insulating film farther from a data line.

A thickness of a thickest portion of the first insulating film may be substantially same as a thickness of the data lines.

A difference between a thickness of a thickest portion of the first insulating film and a thickness of the data lines may be within about 20 nm (200 Å).

The first insulating film and the second insulating film may include an organic material.

The first insulating film and the second insulating film may include a same material.

A material of the first insulating film and a material of the second insulating film may be different from each other.

The first insulating film may include a black material.

The second insulating film may include a black material.

The display device may further include an interlayer film disposed between the data lines and at least one of the first insulating film and the second insulating film.

The interlayer film may include an inorganic material, and the first insulating film and the second insulating film may include an organic material.

The first insulating film and the second insulating film may include a same material.

A material of the first insulating film and a material of the second insulating film may be different from each other.

The first insulating film may include a black material.

The second insulating film may include a black material.

Another embodiment of the invention provides a manufacturing method of a display device that may include forming a data line on a substrate, forming a first insulating film on the data line, exposing and developing the first insulating film by using a mask, and forming a second insulating film on the first insulating film. The exposing and developing of the first insulating film by using the mask includes eliminating the first insulating film overlapping the data line in a direction perpendicular to the substrate.

A sum of thicknesses of the first insulating film and the second insulating film may be about 1.0 µm to about 2.0 µm.

The mask may include a transmissive portion overlapping the data line and a halftone portion overlapping an area between the data line and another data line.

After the exposing and developing of the first insulating film by using the mask, the first insulating film may be disposed between the data line and another data line, and a thickness of a portion of the first insulating film closer to a data line is smaller than a thickness of a portion of the first insulating film father from a data line.

After the exposing and developing of the first insulating film by using the mask, a difference between a thickness of a thickest portion of the first insulating film and a thickness of the data line may be within about 20 nm (200 Å).

A material of the first insulating film and a material of the second insulating film may be different from each other.

The first insulating film or the second insulating film may include a black material.

According to an aspect, there is provided a display device as set out in claim 1. Additional features are set out in claims 2 to 15. According to the embodiments, it is possible to provide a display device and a manufacturing method thereof that may improve light scattering and minimize outgas generation.

### BRIEF DESCRIPTION OF THE DRAWINGS

FIG. 1 schematically illustrates a display device according to an embodiment of the invention.
FIG. 2 schematically illustrates a cross-sectional view taken along line II-II' of FIG. 1.
FIG. 3 illustrates a schematic cross-sectional view of a display device in which a first electrode may be disposed on an insulating film having a step.
FIG. 4 schematically illustrates a cross-sectional view of a display device in which an insulating film includes a first insulating film and a second insulating film.
FIG. 5 schematically illustrates a result of measuring a thickness and light scattering of each layer with respect to a structure (Example 1) of an insulating film having a double layer as in the embodiment of FIG. 2 and a structure (Example 2) of an insulating film having a single layer as in the embodiment of FIG. 3.
FIG. 6 schematically illustrates the same cross-sectional view as FIG. 2 in a display device according to another embodiment of the invention.
FIG. 7 schematically illustrates the same cross-sectional view as FIG. 2 in a display device according to another embodiment.
FIG. 8 schematically illustrates the same cross-sectional view as FIG. 7 in a display device according to another embodiment.
FIG. 9 schematically illustrates the same cross-sectional view as FIG. 2 in a display device according to another embodiment.
FIG. 10 schematically illustrates the same cross-sectional view as FIG. 7 in a display device according to another embodiment.
FIG. 11 schematically illustrates the same cross-sectional view as FIG. 8 in a display device according to another embodiment.
FIG. 12 schematically illustrates the same cross-sectional view as FIG. 9 in a display device according to another embodiment.
FIG. 13 to FIG. 17 schematically illustrate manufacturing processes of the insulating film 180 according to an embodiment of the invention.
FIG. 18 schematically illustrates an equivalent circuit diagram of a pixel of a light emitting diode display according to an embodiment.
FIG. 19 schematically illustrates a layout diagram of one pixel area of a light emitting diode display according to an embodiment.
FIG. 20 schematically illustrates a cross-sectional view taken along line XX-XX' of FIG. 19.

### DETAILED DESCRIPTION OF THE EMBODIMENTS

The invention will be described more fully hereinafter with reference to the accompanying drawings, in which embodiments of the invention are shown. As those skilled in the art would realize, the described embodiments may be modified in various different ways, all without departing from the spirit or scope of the disclosure.

Parts that may be irrelevant to the description may be omitted to clearly describe the disclosure, and like reference numerals designate like elements throughout the specification.

Further, in the drawings, the size and thickness of each element may be arbitrarily illustrated for ease of description, and the disclosure is not necessarily limited to those illustrated in the drawings. In the drawings, the thicknesses of layers, films, panels, regions, etc., may be exaggerated for clarity. In the drawings, for ease of description, the thicknesses of some layers and areas may be exaggerated.

It will be understood that when an element such as a layer, film, region, or substrate may be referred to as being "on" another element, it can be directly on the other element or intervening elements may also be present. In contrast, when an element may be referred to as being "directly on" another element, there may be no intervening elements present. Further, in the specification, the word "on" or "above" means disposed or positioned on or below the object portion, and does not necessarily mean disposed or positioned on the upper side of the object portion based on a gravitational direction.

Unless explicitly described to the contrary, the words "comprise", "has", "have", and "include", and variations such as "comprises", "comprising", "having", "includes", and "including" will be understood to imply the inclusion of stated elements but not the exclusion of any other elements.

Further, the phrase "in a plan view" may mean viewing a target portion from the top, and the phrase "in a cross-sectional view" may mean viewing a cross-section formed by vertically cutting a target portion from the side.

Terms such as "overlap" may include layer, stack, face or facing, extending over, extending under, covering or partly covering or any other suitable term as would be appreciated and understood by those of ordinary skill in the art. Phrases such as "do not overlap" may include apart from or set aside from or offset from and any other suitable equivalents as would be appreciated and understood by those of ordinary skill in the art.

The phrase "at least one of" is intended to include the meaning of "at least one selected from the group of" for the purpose of its meaning and interpretation. For example, "at least one of A and B" may be understood to mean "A, B, or A and B."

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 5% of the stated value.

The term "and/ or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

Unless otherwise defined, all terms used herein (including technical and scientific terms) have the same meaning as commonly understood by those skilled in the art to which this disclosure pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the specification.

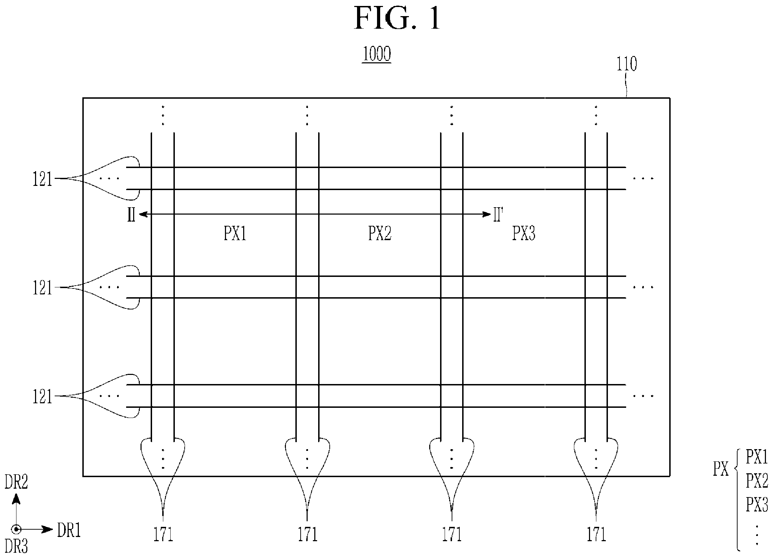

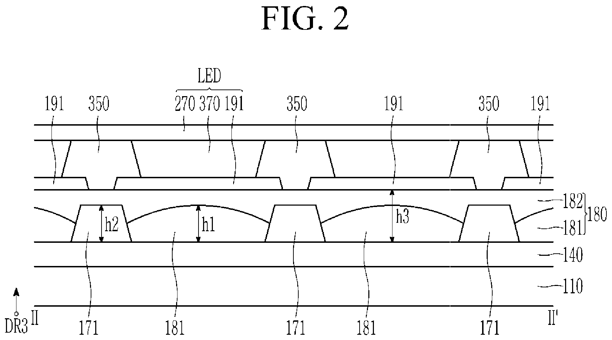

Hereinafter, a display device according to an embodiment of the invention will be described in detail with reference to the accompanying drawings. FIG. 1 schematically illustrates a display device according to an embodiment of the invention. FIG. 2 schematically illustrates a cross-sectional view taken along line II-II' of FIG. 1.

Referring to FIG. 1, a display device 1000 according to an embodiment of the invention may include a gate line 121 disposed along a first direction DR1 and a data line 171 disposed along a second direction DR2.

As shown in FIG. 1, an area partitioned by the gate line 121 and the data line 171 that cross each other may correspond to one pixel PX. Although not shown in FIG. 1, each pixel PX may be provided with a first electrode (not shown). The first electrode (not shown) may be electrically connected to a transistor (not shown) of each pixel PX. The first electrode (not shown) forms a light emitting element (or light emitting diode) together with another electrode and a light emitting layer, and light may be emitted from the light emitting element electrically connected to each pixel.

FIG. 2 illustrates a cross-sectional view taken along line II-II' of FIG. 1. FIG. 2 schematically illustrates only some elements for better comprehension and ease of description, but embodiments of the invention are not limited thereto.

Referring to FIG. 2, a gate insulating film 140 may be disposed on a first substrate 110. Although not shown in FIG. 2, a gate line (not shown) and the like may be further disposed between the first substrate 110 and the gate insulating film 140.

The data line 171 may be disposed on the gate insulating film 140. Although not shown in FIG. 2, an interlayer insulating film (not shown) and the like may be further disposed between the gate insulating film 140 and the data line 171. This depends on a specific structure of the display device, so embodiments of the invention are not limited thereto.

Referring to FIG. 2, a first insulating film 181 may be disposed between the data lines 171 adjacent to each other in the first direction DR1. The first insulating film 181 may be disposed between adjacent data lines 171, and may not overlap the data lines 171 in a direction perpendicular to the first substrate 110. For example, the first insulating films 181 may be separated from each other with the data line 171 therebetween for each pixel. In other words, the first insulating film 181 may comprise a plurality of first insulating film portions, with each first insulating film portion being between two adjacent data lines.

The first insulating film 181 may have a shape in which a thickness of a central portion thereof may be the thickest and a thickness thereof becomes thinner closer to the data line 171. For example, an upper surface of the first insulating film 181 may be a curved surface.

As shown in FIG. 2, the first insulating film 181 may increase in thickness toward the center away from the data line 171. However, a maximum thickness h1 of the first insulating film 181 may not be thicker than a thickness h2 of the data line 171. In the specification, the thickness h1 of the first insulating film 181 means a thickness of the thickest portion in the third direction DR3.

In an embodiment, the thickness h1 of the first insulating film 181 may be substantially the same as the thickness h2 of the data line 171. In the specification, substantially the same thickness may mean that a thickness difference may be within about 20 nm (200 Å) in consideration of a process error. For example, a difference between the thickness h1 of the first insulating film 181 and the thickness of the data line 171 may be about 20 nm (200 Å).

The first insulating film 181 may include an organic material. For example, the first insulating film 181 may include one or more of a polyacrylates resin, an epoxy resin, a phenolic resin, a polyamide resin, a polyimide resin, an unsaturated polyester resin, a polyphenylene ether resin, a polyphenylene sulfide resin, and a benzocyclobutene (BCB). The first insulating film 181 may be transparent, or it may have a color according to an embodiment.

Referring back to FIG. 2, a second insulating film 182 may be disposed on the first insulating film 181. The second insulating film 182 may be disposed on an upper portion of the first insulating film 181 and an upper portion of the data line 171. The second insulating film 182 may include an organic material. For example, the second insulating film 182 may include one or more of a polyacrylates resin, an epoxy resin, a phenolic resin, a polyamide resin, a polyimide resin, an unsaturated polyester resin, a polyphenylene resin, a polyphenylene sulfide resin, and a benzocyclobutene (BCB). The second insulating film 182 may be transparent, or it may have a color according to an embodiment.

The first insulating film 181 and the second insulating film 182 may include the same material, or may include different materials. The first insulating film 181 or the second insulating film 182 may have a color. Other specific embodiments will be described later.

The first insulating film 181 and the second insulating film 182 may form an insulating film 180. A thickness h3 of the insulating film 180 may be about 1.0 µm to about 2.0 µm. The thickness of the insulating film 180 means a thickness of the thickest portion in the third direction DR3.

Referring to FIG. 2, a first electrode 191 may be disposed on the second insulating film 182. Although not illustrated, the first electrode 191 may be electrically connected to a transistor disposed in each pixel. Referring to FIG. 2, a step caused by the data line 171 may be flattened by the first insulating film 181 and the second insulating film 182. For example, a step between a portion in which the data line 171 may be disposed and a portion in which the data line 171 may not be disposed may be filled with the first insulating film 181 and the second insulating film 182. Accordingly, the first electrode 191 may be disposed on the flat second insulating film 182. Although described in detail later, the step between the data lines 171 may be compensated by the first insulating film 181 disposed between the data lines 171 and the second insulating film 182 covering the data line 171 and the first insulating film 181. Accordingly, the thickness of the insulating film 180 may be about 1.0 µm to about 2.0 µm while reducing light scattering of the display device due to the step, thereby minimizing outgassing.

Referring to FIG. 2, a partition wall 350 may be disposed on the first electrode 191. The partition wall 350 may be provided with an opening overlapping the first electrode 191. A light emitting layer 370 may be disposed in the opening of the partition wall 350. A second electrode 270 may be disposed on the partition wall 350 and the light emitting layer 370. The first electrode 191, the light emitting layer 370, and the second electrode 270 may form a light emitting diode LED.

In the display device according to an embodiment, the insulating film 180 that may be disposed between the data line 171 and the first electrode 191 may have a multilayer structure of the first insulating film 181 and the second insulating film 182. The first insulating film 181 may be disposed between the adjacent data lines 171, and may not overlap the data lines 171 in the third direction DR3. The second insulating film 182 may be disposed on the first insulating film 181 and the data line 171. The thickness of the insulating film 180 including the first insulating film 181 and the second insulating film 182 may be about 1.0 µm to about 2.0 µm.

A step may occur due to a height difference between a region in which the data line 171 may be disposed and a region in which the data line 171 may not be disposed, and in case that the insulating film 180 may be formed thereon, a step may also occur in the insulating film 180. As described above, in case that the first electrode 191 may be disposed on the insulating film 180 in which the step may be formed, light scattering may occur at the first electrode 191, thereby reducing display performance of the display device.

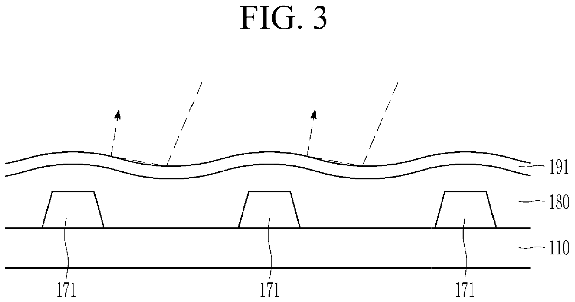

FIG. 3 illustrates a schematic cross-sectional view of a display device in which a first electrode 191 may be disposed on an insulating film 180 having a step. As shown by arrows in FIG. 3, light may be diffusely reflected on a stepped surface of the first electrode 191 to cause light scattering. In case that the insulating film 180 may be formed to have a multilayer structure of an organic material, the light scattering may be reduced.

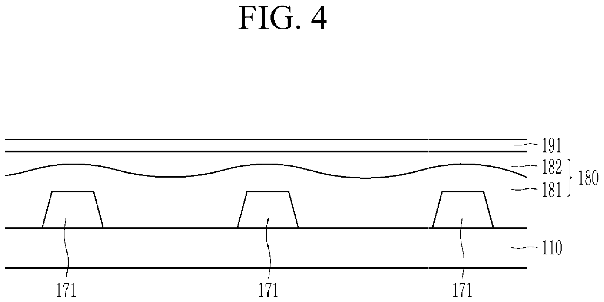

FIG. 4 schematically illustrates a cross-sectional view of a display device in which the insulating film 180 has a multilayer structure of the first insulating film 181 and the second insulating film 182. As shown in FIG. 4, in case that the insulating film 180 has the multilayer structure of the first insulating film 181 and the second insulating film 182, an upper surface of the insulating film 180 may be flattened. This may be because the step may be first flattened by the first insulating film 181, and the step that may be first flattened may be again flattened by the second insulating film 182.

However, as shown in FIG. 4, in case that the first insulating film 181 and the second insulating film 182 may be flattened, the overall thickness of the insulating film 180 may be increased. Generally, in case that the insulating film 180 may be formed e.g., as shown in FIG. 4, it may not be easy to form it to be a certain thickness or less.

For example, a thickness of the first insulating film 181 may be about 0.8 µm to about 1.2 µm. A thickness of the second insulating film 182 may be about 1.4 µm to about 1.8 µm. An entire thickness of the insulating film 180 including the first insulating film 181 and the second insulating film 182 may be about 2.2 µm to about 3.0 µm. Although the thickness ranges may be appropriate thickness ranges for flattening of the insulating film 180, a large amount of outgas may occur in the insulating film 180 due to its thick thickness.

Table 1 below shows a step measurement result according to the thickness of the insulating film 180 in the display device having the structure as shown in FIG. 3 and FIG. 4.

**Table 1**

| Thickness of insulating film | 1.65 µm (single layer) | 1.9 µm (single layer) | 1.65 µm + 1.65 µm (double layer) |
|---|---|---|---|
| Step measurement result | 255 nm | 177 nm | 34 nm |

Referring to Table 1, in case that the thickness of the insulating film is increased, the step is improved, and particularly, in case it is formed to have the double layer as shown in FIG. 4, it can be seen that the step improvement effect may be remarkable. However, in case that the insulating film 180 may be formed as a double layer to improve the step, the thickness of the insulating film 180 becomes thick, and a lot of outgas may be generated in the thickened insulating film 180. The outgas in the insulating film 180 may be a component contained in the organic material of the insulating film 180 that may be released out of the film, thus reliability of the display device may be reduced due to the outgas. As the thickness of the insulating film 180, which may be an organic layer, increases, an amount of the outgas generated in the insulating film 180 may increase, and thus the reliability of the display device may decrease.

However, in the display device according to an embodiment of the invention, as shown in FIG. 2, the first insulating film 181 may be formed between the adjacent data lines 171, and the second insulating film 182 may be formed on the data line 171 and the first insulating film 181. As such, in case that the first insulating film 181 may be formed between the data lines 171 to not overlap the data lines 171, an upper surface of the insulating film 180 may be sufficiently flattened while reducing the thickness of the entire insulating film 180. In the display device according to an embodiment, an entire thickness of the insulating film 180 including the first insulating film 181 and the second insulating film 182 may be about 1.0 µm to about 2.0 µm.

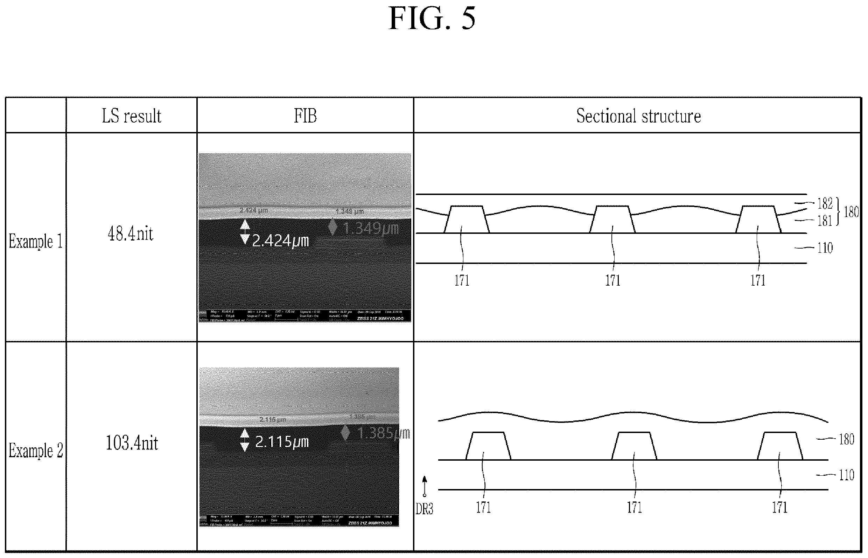

FIG. 5 schematically illustrates a result of measuring a thickness and light scattering of each layer with respect to a structure (Example 1) of an insulating film 180 having a multilayer as in the embodiment of FIG. 2 and a structure (Example 2) of an insulating film 180 having a single layer as in the embodiment of FIG. 3.

Referring to FIG. 5, in a case of Example 1, even in case that the insulating film 180 is a multilayer, it can be seen that it has a film thickness similar to that of Example 2. For example, in case that the first insulating film 181 according to an embodiment may be formed between the data lines 171 and the second insulating film 182 may be formed on the first insulating film 181 and the data line 171, it may be possible to have a film thickness that may be similar to that of a case of forming the insulating film 180 in a single layer.

However, referring to FIG. 5, even though the display device according to Example 1 may have a film thickness similar to that of Example 2, it may be confirmed that the light scattering may be significantly reduced compared to that of Example 1. For example, in a result of light scattering evaluation, luminance of Example 1 may be 48.4 nit, while luminance of Example 2 may be 103.4 nit, and thus the light scattering reduction result of Example 1 may be remarkable despite substantially the same thickness.

As described above, in the display device according to an embodiment of the invention, the first insulating film 181 may be disposed between the adjacent data lines 171, and the second insulating film 182 may be disposed on the data line 171 and the first insulating film 181. By having such a multi-layered structure, while the entire film thickness thereof may be made thin to a level similar to that of a single film, it may be possible to have a remarkably improved flattening effect compared to the single film.

Therefore, it may be possible to prevent the light scattering and to minimize outgas occurrence.

Particularly, in a case of a vehicle display device among the display devices, light scattering by external light may be a problem. In the case of the vehicle display device, since it may be exposed to external light, it may be desirable to maintain high luminance and minimize light scattering. Since the display device according to an embodiment may minimize light scattering, it may be particularly suitable for application to the vehicle display device.

Hereinafter, a display device according to another embodiment of the invention will be described.

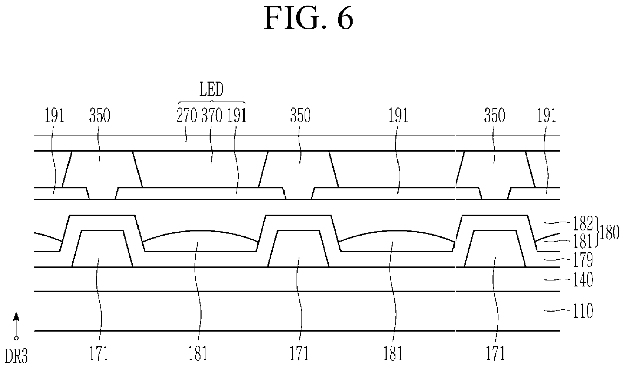

FIG. 6 schematically illustrates the same cross-sectional view as FIG. 2 in a display device according to another embodiment of the invention. Referring to FIG. 6, in the display device according to an embodiment, an interlayer film 179 may be disposed between the data line 171 and the first insulating film 181. The interlayer film 179 may include an inorganic material. The interlayer film 179 may include a silicon oxide, a silicon nitride, or a combination thereof. The interlayer film 179 may protect the data line 171 and the like. Even in case that the interlayer film 179 may be included as shown in FIG. 6, as in FIG. 2, the insulating film 180 may be flattened by a multilayer structure of the first insulating film 181 and the second insulating film 182, and thus it may be possible to prevent light scattering and minimize outgas occurrence.

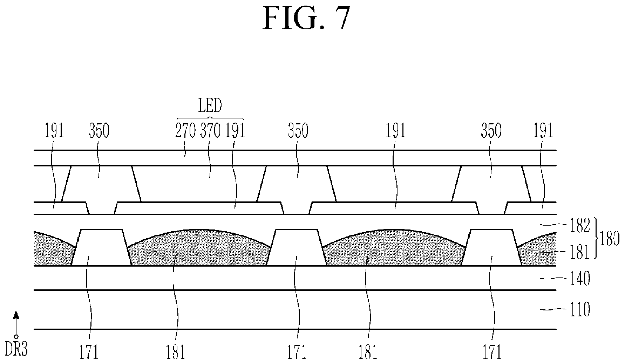

FIG. 7 schematically illustrates the same cross-sectional view as FIG. 2 in a display device of another embodiment. Referring to FIG. 7, the display device according to an embodiment may be the same as the embodiment of FIG. 2, except that the first insulating film 181 may include a black material. The black material may be a material with a black color, and in case that the first insulating film 181 includes the black material, it may represent a black color. A detailed description of the same constituent elements will be omitted. As shown in FIG. 7, in case that the first insulating film 181 includes a black material, a boundary with the second insulating film 182 not including a black material may be clearly viewed. An effect of preventing light scattering and minimizing outgas occurrence may be the same as that of FIG. 2.

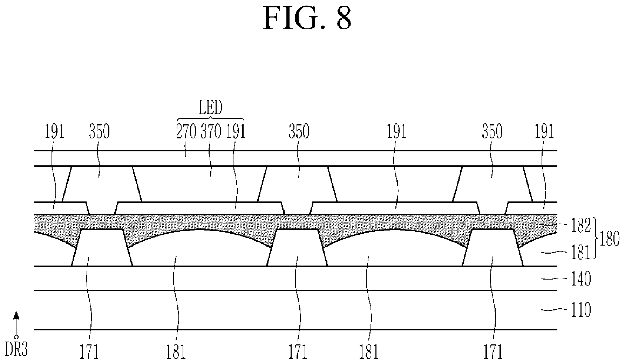

FIG. 8 schematically illustrates the same cross-sectional view as FIG. 7 in a display device according to another embodiment. Referring to FIG. 8, the display device according to an embodiment may be the same as the embodiment of FIG. 7, except that the second insulating film 182 may include a black material. A detailed description of the same constituent elements will be omitted. As shown in FIG. 8, in case that the second insulating film 182 includes a black material, a boundary with the first insulating film 181 not including a black material may be clearly viewed. An effect of preventing light scattering and minimizing outgas occurrence may be the same as that of FIG. 2.

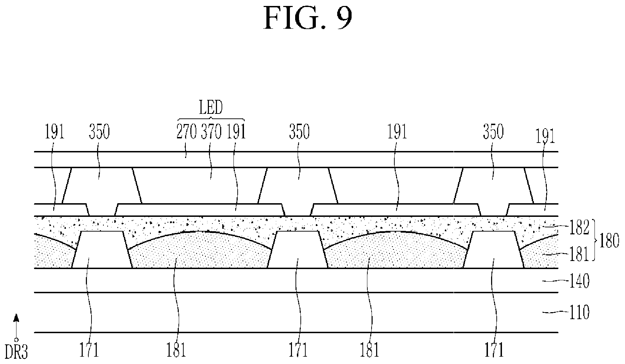

FIG. 9 schematically illustrates the same cross-sectional view as FIG. 2 in a display device according to another embodiment. Referring to FIG. 9, in the display device according to an embodiment, the first insulating film 181 and the second insulating film 182 may include different organic materials. A result of analyzing components of the first insulating film 181 and a result of analyzing components of the second insulating film 182 may be different from each other, and a boundary between the first insulating film 181 and the second insulating film 182 may be viewed.

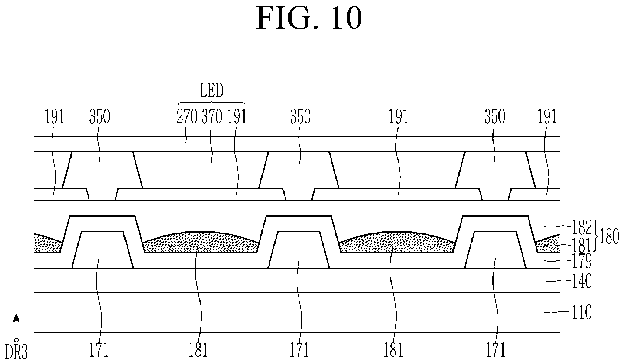

FIG. 10 schematically illustrates the same cross-sectional view as FIG. 7 in a display device according to another embodiment. Referring to FIG. 10, the display device according to an embodiment may be the same as the embodiment of FIG. 7, except that the interlayer film 179 may be disposed between the data line 171 and the first insulating film 181. A detailed description of the same constituent elements will be omitted. The interlayer film 179 may include an inorganic material.

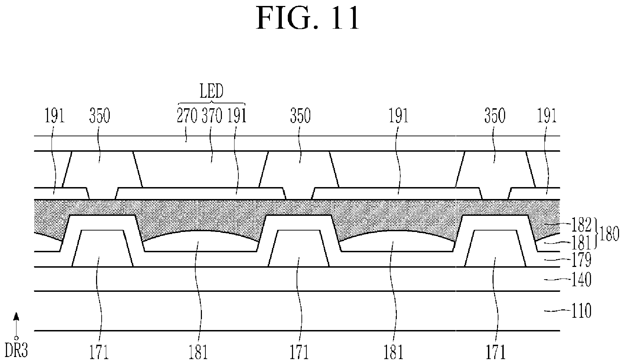

FIG. 11 schematically illustrates the same cross-sectional view as FIG. 8 in a display device according to another embodiment. Referring to FIG. 11, the display device according to an embodiment may be the same as the embodiment of FIG. 8, except that the interlayer film 179 may be disposed between the data line 171 and the first insulating film 181. A detailed description of the same constituent elements will be omitted. The interlayer film 179 may include an inorganic material.

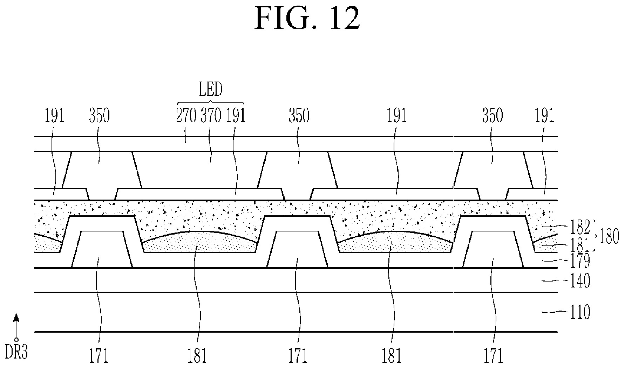

FIG. 12 schematically illustrates the same cross-sectional view as FIG. 9 in a display device according to another embodiment. Referring to FIG. 12, the display device according to an embodiment may be the same as the embodiment of FIG. 8, except that the interlayer film 179 may be disposed between the data line 171 and the first insulating film 181. A detailed description of the same constituent elements will be omitted. The interlayer film 179 may include an inorganic material.

Hereinafter, a manufacturing method of a display device according to an embodiment of the invention will be described in detail with reference to the accompanying drawings.

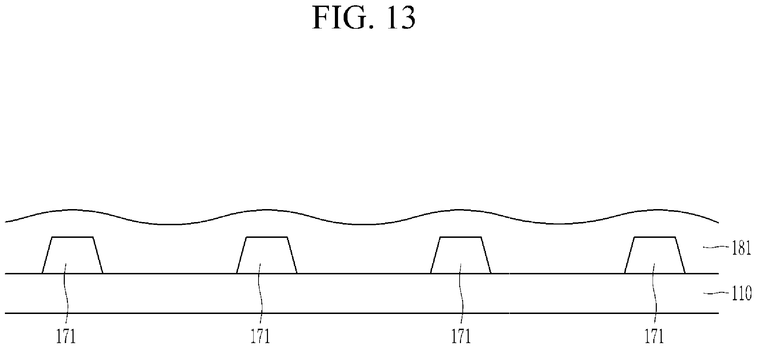

FIG. 13 to FIG. 17 schematically illustrate manufacturing processes of the insulating film 180 according to an embodiment of the invention.

Referring to FIG. 13, the first insulating film 181 may be formed on the data line 171 disposed on the substrate 110. For better comprehension and ease of description, in the cross-sectional view of FIG. 13, a structure including only the substrate 110 and the data line 171 is simply illustrated, and various structures that may be disposed between the substrate 110 and the data line 171 may be omitted.

Referring to FIG. 13, in a process of FIG. 13, the first insulating film 181 may be disposed (e.g., formed) between the data lines 171 and on the data lines 171. An upper portion of the first insulating film 181 may have a step due to a step of the data line 171.

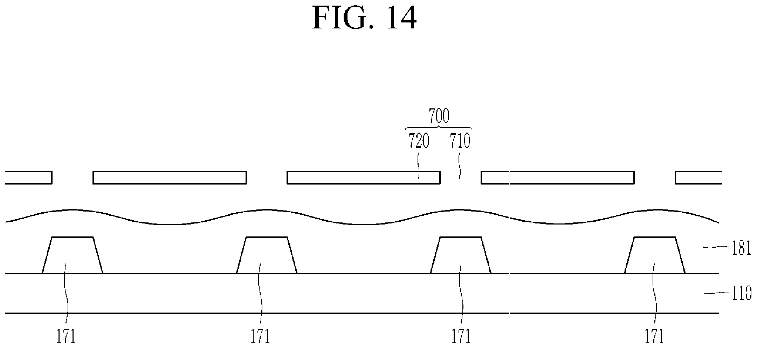

Then, referring to FIG. 14, the first insulating film 181 may be exposed to light by using a mask 700. An opening 710 of the mask 700 may correspond to a region in which the data line 171 may be disposed, and a halftone portion 720 may correspond to a region between the data lines 171. The halftone portion 720 may not completely block light. For example, the mask 700 may be a halftone mask, and light transmittance of the halftone portion 720 may be about 10 % to about 20 %.

The first insulating film 181 disposed on an upper portion of the data line 171 corresponding to the opening 710 of the mask 700 may be largely exposed, and the first insulating film 181 disposed between the data lines 171 corresponding to the halftone portion 720 may be less exposed.

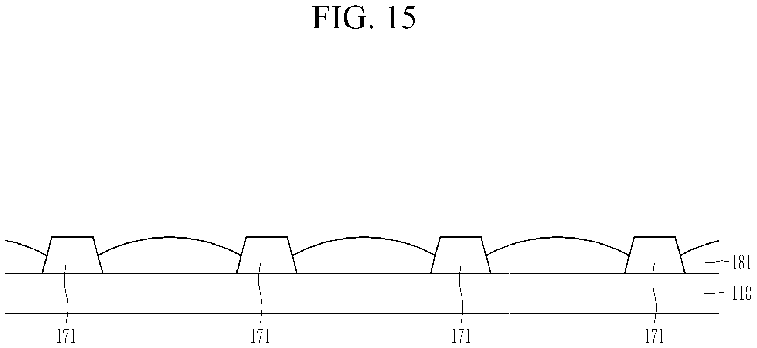

Then, referring to FIG. 15, the first insulating film 181 may be developed. During a development process, the first insulating film 181 disposed on the upper portion of the data line 171 that corresponds to the opening 710 of the mask 700 and thus is largely exposed may be removed. However, the first insulating film 181 between the data lines 171 that corresponds to the halftone portion 720 of the mask 700 and is less exposed may only decrease in thickness and may not be wholly removed.

Therefore, as shown in FIG. 15, the first insulating film 181 on the upper portion of the data line 171 may be removed by a developing process, and the first insulating film 181 may be disposed only between the data lines 171. The first insulating film 181 disposed between the data lines 171 may have a shape in which the thickness thereof increases as being farther away from the data line 171. This may be because a region of the first insulating film 181 adjacent to the opening 710 may be exposed more than other regions by light incident on a side surface of the opening 710 of the mask 700.

Referring to FIG. 15, the thickness of the first insulating film 181 may be substantially the same as that of the data line 171. A difference between the thickness of the first insulating film 181 and the thickness of the data line 171 may be within about 20 nm (200 Å).

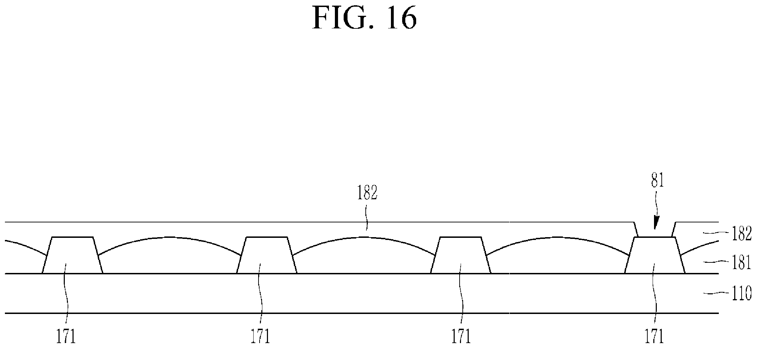

Referring to FIG. 16, the second insulating film 182 may be disposed (e.g., formed) on the first insulating film 181. Since the step may be minimized while the first insulating film 181 fills a space between the adjacent data lines 171, the upper surface of the second insulating film 182 may be flattened. For example, even though the second insulating film 182 is not thickly formed, the upper surface thereof may be flattened.

The second insulating film 182 may include an opening 81. The opening 81 may overlap the data line 171, and the data line 171 and the first electrode 191 may be electrically connected in the opening 81. For better comprehension and ease of description, in FIG. 13 to FIG. 17, although they may be illustrated as the data line 171, the data line 171 may represent all of data conductors disposed on the same layer as the data line. For example, the opening 81 may be disposed to overlap the drain electrode (not shown) disposed on the same layer as the data line.

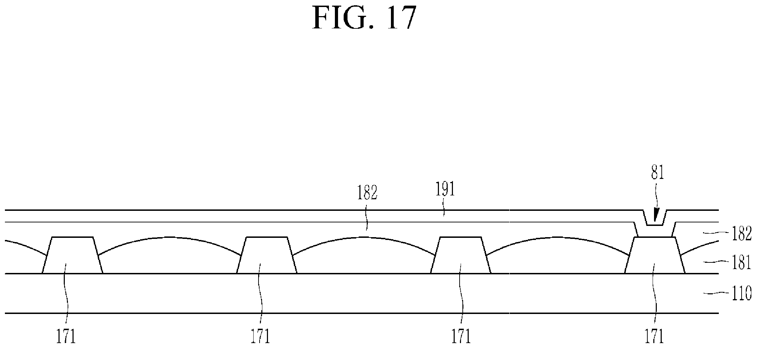

Referring to FIG. 17, the first electrode 191 may be formed on the second insulating film 182. The first electrode 191 may contact the data line 171 through the opening 81. Since the upper portion of the second insulating film 182 may be flat, the first electrode 191 may also be formed flat, thus reducing light scattering.

For better comprehension and ease of description, in FIG. 16 and FIG. 17, the opening 81 may be illustrated only in some of the data lines 171. However, each pixel may include the opening 81, and the transistor and the first electrode may be electrically connected to each other in the opening 81.

Hereinafter, a structure of a display device according to an embodiment of the invention will be described in detail with reference to a specific display device as an example. However, it is merely an example, and embodiments of the invention are not limited to the structure described below.

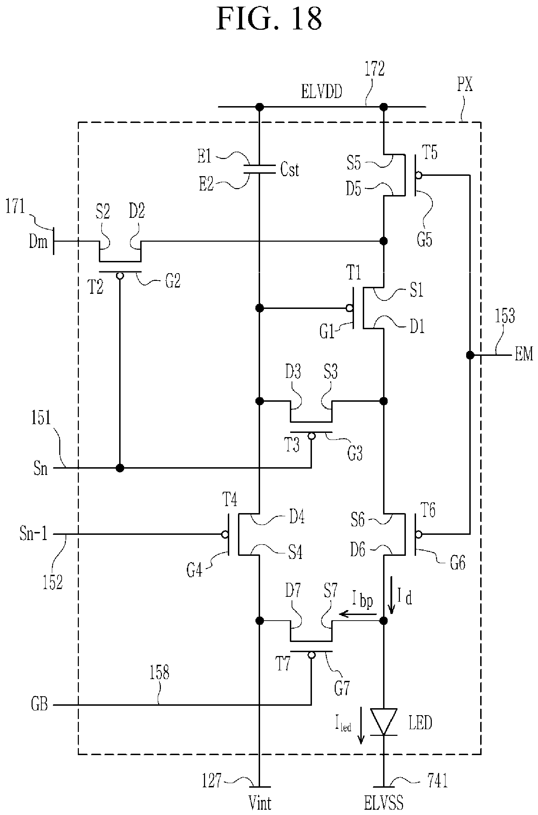

Hereinafter, a pixel structure of a display area will be described with reference to FIG. 18 to FIG. 20. FIG. 18 schematically illustrates an equivalent circuit diagram of one pixel of a light emitting diode display according to an embodiment.

Referring to FIG. 18, a pixel PX of a light emitting diode display may include transistors T1, T2, T3, T4, T5, T6, and T7 electrically connected to signal lines 127, 151, 152, 153, 158, 171, 172, and 741, a storage capacitor Cst, and a light emitting diode LED.

The light emitting diode display may include a display area in which an image may be displayed, and the pixels PX may be disposed (e.g., arranged) in various shapes in the display area.

Transistors T1, T2, T3, T4, T5, T6, and T7 may include a driving transistor T1, switching transistors electrically connected to a scan line 151, for example, a second transistor T2 and a third transistor T3, and the other transistors may be transistors (hereinafter referred to as compensating transistors) for performing operations required to drive the light emitting diodes LED. The compensating transistors T4, T5, T6, and T7 may include a fourth transistor T4, a fifth transistor T5, a sixth transistor T6, and a seventh transistor T7.

The signal lines 127, 151, 152, 153, 158, 171, 172, and 741 may include the scan line 151, a previous scan line 152, a light emitting control line 153, a bypass control line 158, a data line 171, a driving voltage line 172, an initializing voltage line 127, and a common voltage line 741. The bypass control line 158 may be a portion of the previous scan line 152 or may be electrically connected thereto.

The scan line 151 may be electrically connected to a gate driver to transmit a scan signal Sn to the second transistor T2 and the third transistor T3. The previous scan line 152 may be electrically connected to the gate driver, and may transmit a previous scan signal Sn-1 applied to the pixel PX disposed at a previous stage thereof to the fourth transistor T4. The light emitting control line 153 may be electrically connected to a light emitting control portion, and may transmit a light emitting control signal EM for controlling a light emitting time of the light emitting diode LED to the fifth transistor T5 and the sixth transistor T6. The bypass control line 158 may transmit a bypass signal GB to the seventh transistor T7.

The data line 171 may be a wire for transmitting a data voltage Dm generated in the data driving portion, and luminance at which the light emitting diode (LED) (also referred to as the light emitting element) emits may vary in accordance with the data voltage Dm. The driving voltage line 172 may apply a driving voltage ELVDD. The initializing voltage line 127 may transmit an initializing voltage Vint for initializing the driving transistor T1. The common voltage line 741 may apply a common voltage ELVSS. The voltages applied to the driving voltage line 172, the initializing voltage line 127, and the common voltage line 741 may be constant.

Hereinafter, transistors will be described.

The driving transistor T1 may be a transistor that adjusts a current outputted according to the applied data voltage Dm. An outputted driving current Id may be applied to the light emitting diode LED to adjust brightness of the light emitting diode LED according to the data voltage Dm. To this end, a first electrode S1 of the driving transistor T1 may be disposed to receive the driving voltage ELVDD. The first electrode S1 may be electrically connected to the driving voltage line 172 via the fifth transistor T5. The first electrode S1 of the driving transistor T1 may be electrically connected to a second electrode D2 of the second transistor T2 to receive the data voltage Dm. A second electrode D1 (output electrode) of the driving transistor T1 may be disposed to be able to output a current to the light emitting diode LED. The second electrode D1 of the driving transistor T1 may be electrically connected to an anode of the light emitting diode LED via the sixth transistor T6. On the other hand, the gate electrode G1 of the driving transistor T1 may be electrically connected to one electrode (second storage electrode E2) of the storage capacitor Cst. Accordingly, a voltage of the gate electrode G1 may vary depending on a voltage stored in the storage capacitor Cst, thus the driving current Id outputted by the driving transistor T1 may vary.

The second transistor T2 may be a transistor for receiving the data voltage Dm into the pixel PX. A gate electrode G2 thereof may be electrically connected to the scan line 151, and a first electrode S2 thereof may be electrically connected to the data line 171. The second electrode D2 of the second transistor T2 may be electrically connected to the first electrode S1 of the driving transistor T1. In case that the second transistor T2 may be turned on depending on the scan signal Sn transmitted through the scan line 151, the data voltage Dm transmitted through the data line 171 may be transmitted to the first electrode S1 of the driving transistor T1.

The third transistor T3 may be a transistor that allows a compensation voltage (a voltage of Dm+Vth) in which the data voltage Dm may be changed while passing through the driving transistor T1 to be transmitted to a second storage electrode E2 of the storage capacitor Cst. A gate electrode G3 thereof may be electrically connected to the scan line 151, and a first electrode S3 thereof may be electrically connected to the second electrode D1 of the driving transistor T1. A second electrode D3 of the third transistor T3 may be electrically connected to the second storage electrode E2 of the storage capacitor Cst and the gate electrode G1 of the driving transistor T1. The third transistor T3 may connect the gate electrode G1 and the second electrode D1 of the driving transistor T1 depending on the scan signal Sn received through the scan line 151, and it also may connect the second electrode D1 of the driving transistor T1 and the second storage electrode E2 of the storage capacitor Cst.

The fourth transistor T4 may serve to initialize the gate electrode G1 of the driving transistor T1 and the second storage electrode E2 of the storage capacitor Cst. A gate electrode G4 may be electrically connected to the previous scan line 152, and a first electrode S4 may be electrically connected to the initializing voltage line 127. A second electrode D4 of the fourth transistor T4 may be electrically connected to the second storage electrode E2 of the storage capacitor Cst and the gate electrode G1 of the driving transistor T1 via the second electrode D3 of the third transistor T3. The fourth transistor T4 may transmit the initializing voltage Vint to the gate electrode G1 of the driving transistor T1 and the second storage electrode E2 of the storage capacitor Cst depending on the previous scan signal Sn-1 received through the previous second scan line 152. Thus, a gate voltage of the gate electrode G1 of the driving transistor T1 and the storage capacitor Cst may be initialized. The initializing voltage Vint may have a low voltage value, which may be a voltage capable of turning on the driving transistor T1.

The fifth transistor T5 may serve to transmit the driving voltage ELVDD to the driving transistor T1. A gate electrode G5 may be electrically connected to the light emitting control line 153, and a first electrode S5 may be electrically connected to the driving voltage line 172. A second electrode D5 of the fifth transistor T5 may be electrically connected to the first electrode S1 of the driving transistor T1.

The sixth transistor T6 may serve to transmit the driving current Id outputted from the driving transistor T1 to the light emitting diode LED. A gate electrode G6 may be electrically connected to the light emitting control line 153, and a first electrode S6 may be electrically connected to the second electrode D1 of the driving transistor T1. A second electrode D6 of the sixth transistor T6 may be electrically connected to the anode of the light emitting diode LED.

The fifth transistor T5 and the sixth transistor T6 may be simultaneously turned on by the light emitting control signal EM received through the light emitting control line 153, and in case that the driving voltage ELVDD may be applied to the first electrode S1 of the driving transistor T1 through the fifth transistor T5, the driving transistor T1 may output the driving current Id according to a voltage (i.e., a voltage of the second storage electrode E2 of the storage capacitor Cst) of the gate electrode G1 of the driving transistor T1. The outputted driving current Id may be transmitted to the light emitting diode LED through the sixth transistor T6. The light emitting diode LED may emit light as a current I_{led} flows therethrough.

The seventh transistor T7 may serve to initialize the anode of the light emitting diode LED. A gate electrode G7 may be electrically connected to the bypass control line 158, a first electrode S7 may be electrically connected to the anode of the light emitting diode LED, and a second electrode D7 may be electrically connected to the initializing voltage line 127. The bypass control line 158 may be electrically connected to the previous scan line 152, and the bypass signal GB may be the same timing signal as the previous scan signal Sn-1. The bypass control line 158 may not be electrically connected to the previous scan line 152, and may transmit a separate signal that may be different from the previous scan signal Sn-1. In case that the seventh transistor T7 may be turned on by the bypass signal GB, the initializing voltage Vint may be applied to the anode of the light emitting diode LED to initialize it.

A first storage electrode E1 of the storage capacitor Cst may be electrically connected to the driving voltage line 172, and the second storage electrode E2 may be electrically connected to the gate electrode G1 of the driving transistor T1, the second electrode D3 of the third transistor T3, and the second electrode D4 of the fourth transistor T4. As a result, the second storage electrode E2 may determine the voltage of the gate electrode G1 of the driving transistor T1, and it may receive the data voltage Dm through the second electrode D3 of the third transistor T3, or receive the initializing voltage Vint through the second electrode D4 of the fourth transistor T4.

On the other hand, an anode of the light emitting diode LED may be electrically connected to the second electrode D6 of the sixth transistor T6 and the first electrode S7 of the seventh transistor T7, and a cathode thereof may be electrically connected to the common voltage line 741 for transmitting the common voltage ELVSS.

In the embodiment of FIG. 18 the pixel circuit includes the seven transistors T1 to T7 and the one capacitor Cst, but embodiments are not limited thereto, and the number of transistors and the number of capacitors and their connections may be variously changed.

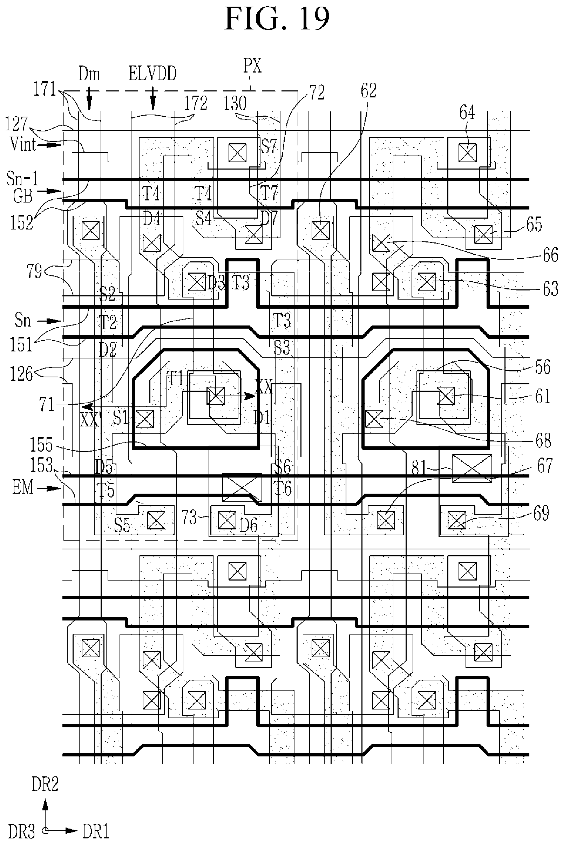

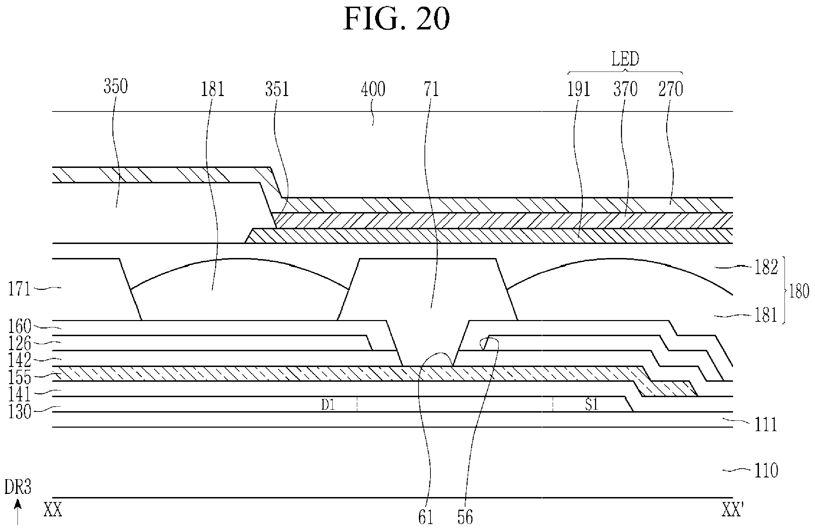

FIG. 19 schematically illustrates a layout diagram of a pixel of a light emitting diode display according to an embodiment, and FIG. 20 schematically illustrates a cross-sectional view taken along line XX-XX' of FIG. 19.

Referring to FIG. 19, the light emitting diode display according to an embodiment may include the scan line 151 extending along the first direction DR1 and transmitting the scan signal Sn, the previous scan line 152 for transmitting the previous scan signal Sn-1, the light emitting control line 153 for transmitting the light emitting control signal EM, and the initializing voltage line 127 for transmitting the initializing voltage Vint. The bypass signal GB may be transmitted through the previous scan line 152.

The light emitting diode display may include the data line 171 extending along the second direction DR2 perpendicular to the first direction DR1 and transmitting the data voltage Dm, and the driving voltage line 172 for transmitting the driving voltage ELVDD.

The light emitting diode display may include the driving transistor T1, the second transistor T2, the third transistor T3, the fourth transistor T4, the fifth transistor T5, the sixth transistor T6, the seventh transistor T7, the storage capacitor Cst, and the light emitting diode LED.

A channel of each of the driving transistor T1, the second transistor T2, the third transistor T3, the fourth transistor T4, the fifth transistor T5, the sixth transistor T6, and the seventh transistor T7 may be disposed in a semiconductor layer 130 extending long. At least some of the first and second electrodes of the transistors T1, T2, T3, T4, T5, T6, and T7 may also be disposed in the semiconductor layer 130. The semiconductor layer 130 may be formed to be bent in various shapes. The semiconductor layer 130 may include a polycrystalline semiconductor such as polysilicon, an oxide semiconductor, or a combination thereof.

The semiconductor layer 130 may include a channel doped with n-type impurities or p-type impurities, and a first doped region and a second doped region that may be disposed at opposite sides of the channel have a higher doping concentration than that of the impurities doped in the channel. The first doped region and the second doped region respectively may correspond to the first electrodes and the second electrodes of the transistors T1, T2, T3, T4, T5, T6, and T7. In case that one of the first doped region and the second doped region may be a source region, the other one may be a drain region. In the semiconductor layer 130, regions between the first and second electrodes of two different transistors may also be doped, so that the two transistors may be electrically connected to each other.

Each of the channels of the transistors T1, T2, T3, T4, T5, T6, and T7 may overlap the gate electrode of each of the transistors T1, T2, T3, T4, T5, T6, and T7, and may be disposed between the first electrode and the second electrode of each of the transistors T1, T2, T3, T4, T5, T6, and T7. The transistors T1, T2, T3, T4, T5, T6, and T7 may have substantially the same stacked structure. Hereinafter, the driving transistor T1 will be described in detail, and the remaining transistors T2, T3, T4, T5, T6, and T7 will be briefly described.

The driving transistor T1 may include a channel, a first gate electrode 155, the first electrode S1, and the second electrode D1. The channel of the driving transistor T1 may be between the first electrode S1 and the second electrode D1, and overlaps the first gate electrode 155 in a plan view. The channel may be curved in order to form a long channel in a limited region. A driving range of the gate voltage applied to the first gate electrode 155 of the driving transistor T1 may be widened as a length of the channel increases, and the driving current Id may steadily increase in accordance with the gate voltage. Accordingly, a gray of light emitted from the light emitting diode LED may be finely controlled by changing the gate voltage, and the display quality of the light emitting diode display may also be improved. Since the channel extends in several directions rather than extending in one direction, effects due to directionality may be offset in a manufacturing process, thereby reducing an effect of process dispersion. Therefore, it may be possible to prevent degradation in image quality such as spot defects (for example, a luminance difference occurring depending on pixels even if the same data voltage Dm may be applied) capable of occurring due to the characteristic of the driving transistor T1 that may be varied according to the region of the display device due to the process dispersion. The shape of the channel is not limited to the illustrated horseshoe shape (Ω shape) in embodiments, and the channel may have various shapes.

The first gate electrode 155 may overlap the channel in a plan view. The first and second electrodes S1 and D1 may be disposed at opposite sides of the channel. An extended portion of a storage line 126 may be isolated and disposed on the first gate electrode 155. The extended portion of the storage line 126 may overlap the gate electrode 155 with a second gate insulating film therebetween in a plan view to form the storage capacitor Cst. The extended portion of the storage line 126 may be a first storage electrode (E1 of FIG. 18) of the storage capacitor Cst, and the first gate electrode 155 may be a second storage electrode (E2 of FIG. 18). The extended portion of the storage line 126 may be provided with an opening 56 so that the gate electrode 155 may be electrically connected to a first data connecting member 71. In the opening 56, an upper surface of the first gate electrode 155 and the first data connecting member 71 may be electrically connected through a contact opening 61. The first data connecting member 71 may be electrically connected to the second electrode D3 of the third transistor T3 to electrically connect the gate electrode 155 of the driving transistor T1 and the second electrode D3 of the third transistor T3.

The gate electrode of the second transistor T2 may be a portion of the scan line 151. The data line 171 may be electrically connected to the first electrode S2 of the second transistor T2 through a contact opening 62. The first electrode S2 and the second electrode D2 may be disposed on the semiconductor layer 130.

The third transistor T3 may be configured of two transistors adjacent to each other. In the pixel PX of FIG. 19, the symbol T3 may be illustrated at a left side and a lower side with respect to the bent portion of the semiconductor layer 130. These two portions serve as the third transistor T3, and the first electrode S3 of one third transistor T3 may be electrically connected to the second electrode D2 of the other third transistor T3. The gate electrodes of the two transistors T3 may be a portion of the scan line 151 or a portion protruding upward from the scan line 151. Such a structure may be regarded as a dual gate structure and may block a leakage current from flowing. The first electrode S3 of the third transistor T3 may be electrically connected to the first electrode S6 of the sixth transistor T6 and the second electrode D1 of the driving transistor T1. The second electrode D3 of the third transistor T3 may be electrically connected to the first data connecting member 71 through a contact opening 63.

The fourth transistor T4 may include two fourth transistors T4, and the two fourth transistors T4 may be formed at a position at which the previous scan line 152 and the semiconductor layer 130 meet. The gate electrode of the fourth transistor T4 may be a portion of the previous scan line 152. The first electrode S4 of one fourth transistor T4 may be electrically connected to the second electrode D4 of the other fourth transistor T4. Such a structure may be regarded as a dual gate structure and may serve to block a leakage current. A second data connecting member 72 may be electrically connected to the first electrode S4 of the fourth transistor T4 through a contact opening 65, and the first data connecting member 71 may be electrically connected to the second electrode D4 of the fourth transistor T4 through the contact opening 63.

As described above, the third transistor T3 and the fourth transistor T4 may be formed to have the dual gate structure to effectively prevent a leakage current from being generated by blocking an electron movement path of a channel in an off state.

The gate electrode of the fifth transistor T5 may be a portion of the light emitting control line 153. The driving voltage line 172 may be electrically connected to the first electrode S5 of the fifth transistor T5 through a contact opening 67, and the second electrode D5 may be electrically connected to the first electrode S1 of the driving transistor T1 through the semiconductor layer 130.

The gate electrode of the sixth transistor T6 may be a portion of the light emitting control line 153. A third data connecting member 73 may be electrically connected to the second electrode D6 of the sixth transistor T6 through a contact opening 69, and the first electrode S6 may be electrically connected to the second electrode D1 of the driving transistor through the semiconductor layer 130.

The gate electrode of the seventh transistor T7 may be a portion of the previous scan line 152. The first electrode S7 of the seventh transistor T7 may be electrically connected to the second electrode D6 of the sixth transistor T6, and the second electrode D7 may be electrically connected to the first electrode S4 of the fourth transistor T4.

The storage capacitor Cst may include the first storage electrode E1 and the second storage electrode E2 which may overlap each other with a second gate insulating film 142 therebetween. The second storage electrode E2 may correspoond to the gate electrode 155 of the driving transistor T1, and the first storage electrode E1 may be the extended portion of the storage line 126. Herein, the second gate insulating film 142 may become a dielectric, and a capacitance may be determined by a charge stored in the storage capacitor Cst and a voltage between the first and second storage electrodes E1 and E2. By using the first gate electrode 155 as the second storage electrode E2, a space capable of forming the storage capacitor Cst in a space that may be narrowed by the channel of the driving transistor T1 occupying a large area in the pixel may be secured.

The driving voltage line 172 may be electrically connected to the first storage electrode E1 through a contact opening 68. Accordingly, the storage capacitor Cst may store a charge corresponding to a difference between the driving voltage ELVDD transmitted to the first storage electrode E1 through the driving voltage line 172 and the gate voltage of the gate electrode 155.

The second data connecting member 72 may be electrically connected to the initializing voltage line 127 through a contact opening 64. The first electrode may be electrically connected to the third data connecting member 73 through the contact opening 81. The first electrode may be a pixel electrode.

A parasitic capacitor control pattern 79 may be disposed between dual gate electrodes of the compensation transistor T3. A parasitic capacitor may exist in the pixel, and image quality characteristics may change in case that the voltage applied to the parasitic capacitor may be changed. The driving voltage line 172 may be electrically connected to the parasitic capacitor control pattern 79 through a contact opening 66. Therefore, it may be possible to prevent the image quality characteristic from being changed by applying the driving voltage ELVDD, which may be a constant DC voltage, to the parasitic capacitor. The parasitic capacitor control pattern 79 may be formed in a different area from that shown, and a voltage other than the driving voltage ELVDD may be applied.

An end of the first data connecting member 71 may be electrically connected to the gate electrode 155 through the contact opening 61, and another end thereof may be electrically connected to the second electrode D3 of the third transistor T3 and the second electrode D4 of the fourth transistor T4 through the contact opening 63.

An end of the second data connecting member 72 may be electrically connected to the first electrode S4 of the fourth transistor T4 through the contact opening 65, and another end thereof may be electrically connected to the initializing voltage line 127 through the contact opening 64.

The third data connecting member 73 may be electrically connected to the second electrode of the sixth transistor T6 through the contact opening 69.

Hereinafter, a sectional structure of the light emitting diode display according to the embodiment will be described according to the stacked order with reference to FIG. 20 in addition to FIG. 19.

The light emitting diode display according to the embodiment may include the first substrate 110.

The first substrate 110 may include a plastic layer (not shown) and a barrier layer (not shown). The plastic layer and the barrier layer may be alternatively stacked on each other.

The plastic layer may include at least one of polyethersulfone (PES), polyacrylate (PAR), polyetherimide (PEI), polyethylene naphthalate (PEN), polyethylene terephthalate (PET), polyphenylene sulfide (PPS), polyarylate, polyimide (PI), polycarbonate (PC), polyarylene(ether sulfone), or a combination thereof.

The barrier layer may include at least one of a silicon oxide, a silicon nitride, and an aluminum oxide, but embodiments may not be limited thereto, and may include any inorganic material.

A buffer layer 111 may be disposed on the first substrate 110. The buffer layer 111 may include an inorganic insulating material such as a silicon oxide, a silicon nitride, an aluminum oxide, or a combination thereof or may include an organic insulating material such as a polyimide acryl.

The semiconductor layer 130 including a channel of the transistors T1, T2, T3, T4, T5, T6, and T7, the first electrode, and the second electrode may be disposed on the buffer layer 111.

A first gate insulating film 141 may be disposed on the semiconductor layer 130. The first gate conductor including the first gate electrode 155, the scan line 151, the previous scan line 152, and the light emitting control line 153 may be disposed on the first gate insulating film 141.

The second gate insulating film 142 covering the first gate conductor may be disposed on the first gate conductor. The first gate insulating film 141 and the second gate insulating film 142 may include an inorganic insulating material such as a silicon nitride, a silicon oxide an aluminum oxide, or a combination thereof, or an organic insulating material.

A second gate conductor including a storage line 126, an initializing voltage line 127, and a parasitic capacitor control pattern 79 may be disposed on the second gate insulating film 142.

An interlayer insulating film 160 covering the second gate conductor may be disposed on the second gate conductor. The interlayer insulating film 160 may include an inorganic insulating material such as a silicon nitride, a silicon oxide, an aluminum oxide, or a combination thereof, or may include an organic insulating material.

A data conductor including the data line 171, the driving voltage line 172, the first data connecting member 71, the second data connecting member 72, and the third data connecting member 73 may be disposed on the interlayer insulating film 160. The first data connecting member 71 may be electrically connected to the first gate electrode 155 through the contact opening 61.

The insulating film 180 covering the data conductor may be disposed on the data conductor. The insulating film 180 may include the first insulating film 181 and the second insulating film 182. The first insulating film 181 may be disposed in a region between the data conductors. For example, referring to FIG. 20, the first insulating film 181 may be disposed between the data line 171 and the first data connecting member 71. Although not shown, the first insulating film 181 may also be disposed in a region between other data conductors.

The first insulating film 181 may not overlap the data conductor in the third direction DR3. The first insulating film 181 may be disposed between the data conductors and compensate for the step caused by the data conductors.

The second insulating film 182 may be disposed on the first insulating film 181. The second insulating film 182, while covering the first insulating film 181 and the data conductor, flattens the upper portion thereof.

The thickness of the first insulating film 181 may be substantially the same as the thickness of the data conductor. Specifically, the difference between the thickness of the first insulating film 181 and the thickness of the data conductor may be within about 200 Å.

The entire thickness of the insulating film 180 including the first insulating film 181 and the second insulating film 182 may be about 1.0 µm to about 2.0 µm. The entire thickness of the insulating film 180 may be reduced by disposing the first insulating film 181 only between the data conductors. Therefore, the problem caused by the outgassing of the thick insulating film 180 may be minimized.

The first insulating film 181 and the second insulating film 182 may include an organic material. The first insulating film 181 and the second insulating film 182 may include the same material, or may include different materials. One of the first insulating film 181 and the second insulating film 182 may include a black material.

The first electrode 191 may be disposed on the insulating film 180. Since the insulating film 180 may be flattened by the multilayer structures of the first insulating film 181 and the second insulating film 182, the first electrode 191 may be flat. Therefore, light scattering caused by the step of the first electrode 191 may be minimized.

The first electrode 191 may be electrically connected to the third data connecting member 73 through the opening 81 formed in the insulating film 180.

The partition wall 350 may be disposed on the insulating film 180 and the first electrode 191. The partition wall 350 may have an opening 351 overlapping the first electrode 191. A light emitting layer 370 may be disposed in the opening 351. The second electrode 270 may be disposed on the light emitting layer 370 and the partition wall 350. The first electrode 191, the light emitting layer 370, and the second electrode 270 may form the light emitting diode LED. The first electrode 191 may be a pixel electrode, and the second electrode 270 may be a common electrode.

In some embodiments, the pixel electrode may be an anode which may be a hole injection electrode, and the common electrode may be a cathode which may be an electron injection electrode. In contrast, the pixel electrode may be a cathode, and the common electrode may be an anode. In case holes and electrons may be injected into the light emitting layer from the pixel electrode and the common electrode, respectively, light may be emitted in case that excitons of which the injected holes and electrons may be combined enter a ground state from an excited state.

An encapsulation layer 400 for protecting the light emitting diode LED may be disposed on the second electrode 270. The encapsulation layer 400 may be in contact with the second electrode 270 as shown, and in some embodiments, it may be spaced apart from the diode second electrode 270.

The encapsulation layer 400 may be a thin film encapsulation layer in which an inorganic film and an organic film may be stacked, and may include a triple layer formed of an inorganic film, an organic film, and an inorganic film. In some embodiments, a capping layer and a functional layer may be disposed between the second electrode 270 and the encapsulation layer 400.

As discussed, embodiments can provide a display device, comprising: gate lines disposed over a substrate in a first direction; data lines disposed over the substrate in a second direction crossing the first direction, the data lines being insulated from the gate lines; a first insulating film disposed between the data lines; a second insulating film disposed on the data lines and the first insulating film; and a first electrode disposed over the second insulating film, wherein the first insulating film does not overlap the data lines in a direction perpendicular to the substrate.

The first insulating film may comprise a plurality of first insulating film portions, with each first insulating film portion being between two adjacent data lines.

Each first insulating film portion may have a shape in which a thickness of a central portion thereof may be the thickest and a thickness thereof becomes thinner closer to the data lines. For example, an upper surface of the first insulating film portion may be a curved surface.

In some embodiments, the first insulating film and the data lines are on a same layer. For example, this same layer may be an insulating layer, such as a gate insulating film.

The second insulating film may cover the data lines and the first insulating film. An upper surface of the second insulating film may be flat.

While this invention has been described in connection with what is presently considered to be practical embodiments, it is to be understood that embodiments of the invention are not limited to the disclosed embodiments, but, on the contrary, is intended to cover various modifications and equivalent arrangements included within the scope of the appended claims, including any equivalents.

## Claims

1. A display device, comprising:
gate lines disposed over a substrate in a first direction;
data lines disposed over the substrate in a second direction crossing the first direction, the data lines being insulated from the gate lines;
a first insulating film disposed between the data lines;
a second insulating film disposed over the data lines and the first insulating film; and
a first electrode disposed over the second insulating film,
wherein the first insulating film does not overlap the data lines in a direction perpendicular to the substrate.

2. The display device of claim 1, wherein the first insulating film comprises a plurality of first insulating film portions, with each first insulating film portion being between two adjacent data lines.

3. The display device of claim 1 or 2, wherein the first insulating film and the data lines are on a same layer.

4. The display device of any one of claims 1 to 3, wherein
a sum of thicknesses of the first insulating film and the second insulating film is about 1.0 µm to about 2.0 µm.

5. The display device of any one of claims 1 to 4, wherein
the data lines and the second insulating film directly contact each other.

6. The display device of any one of claims 1 to 5, wherein
a thickness of a portion of the first insulating film closer to a data line is smaller than a thickness of a portion of the first insulating film farther from a data line.

7. The display device of any one of claims 1 to 6, wherein
a thickness of a thickest portion of the first insulating film is substantially same as a thickness of the data lines.

8. The display device of any one of claims 1 to 7, wherein
a difference between a thickness of a thickest portion of the first insulating film and a thickness of the data lines is within about 20 nm.

9. The display device of any one of claims 1 to 8, wherein
the first insulating film and the second insulating film include an organic material.

10. The display device of any one of claims 1 to 9, wherein
the first insulating film and the second insulating film include a same material.

11. The display device of any one of claims 1 to 9, wherein
a material of the first insulating film and a material of the second insulating film are different from each other;
optionally wherein the first insulating film includes a black material;
optionally wherein the second insulating film includes a black material.

12. The display device of any one of claims 1 to 11, further comprising:
an interlayer film disposed between the data lines and at least one of the first insulating film and the second insulating film.

13. The display device of claim 12, wherein
the interlayer film includes an inorganic material, and
the first insulating film and the second insulating film include an organic material.

14. The display device of claim 12 or 13, wherein
the first insulating film and the second insulating film include a same material.

15. The display device of claim 12 or 13, wherein
a material the first insulating film and a material of the second insulating film are different from each other.
